# EUROPEAN PATENT SPECIFICATION

(11) **EP 1 782 957 B1**
(45) Date of publication and mention of the grant of the patent: **08.07.2009**
(21) Application number: 06023075.2
(22) Date of filing: 06.11.2006
(51) Int. Cl.: B41J 2/165

(54) **Liquid ejection apparatus**
Flüssigkeitejektionsgerät
Appareil pour l'éjection de liquide

(30) Priority: 08.11.2005 JP 2005323808
(43) Date of publication of application: 09.05.2007
(73) Proprietor: Seiko Epson Corporation, Shinjuku-ku, Tokyo 163-0811 (JP)
(72) Inventor: Miura, Hirotsuna, Suwa-shi Nagano-ken 392-8502 (JP); Iwata, Yuji, Suwa-shi Nagano-ken 392-8502 (JP)
(74) Representative: HOFFMANN EITLE

(56) References cited:
- WO-A-20/05068508
- US-A1- 2004 113 971

## Description

### BACKGROUND

### 1. Technical Field

The present invention relates to a liquid ejection apparatus.

### 2. Related Art

Typically, a display such as a liquid crystal display or an electroluminescence display includes a substrate that displays an image. The substrate has an identification code (for example, a two-dimensional code) representing encoded information including the site of production and the product number. The identification code is formed by structures (dots formed by colored thin films or recesses) that reproduce the identification code. The structures are provided in multiple dot formation areas (data cells) in accordance with a prescribed pattern.

As a method for forming the identification code, a laser sputtering method and a waterjet method have been described in JP-A-11-77340 and JP-A-2003-127537. In the laser sputtering method, films forming a code pattern are provided through sputtering. The waterjet method involves ejection of water containing abrasive material onto a substrate for marking a code pattern on the substrate.

However, to form the code pattern in a predetermined size by the laser sputtering method, the interval between a metal foil and a substrate must be adjusted to several or several tens of micrometers. The corresponding surfaces of the substrate and the metal foil thus must be extremely flat and the interval between the substrate and the metal foil must be adjusted with accuracy of the order of micrometer. Therefore, the laser sputtering method is applicable only to certain types of substrates, making it difficult to form identification codes in a wider range of substrates. In the waterjet method, water or dust or abrasive may splash onto and contaminate a substrate, when forming a code pattern on the substrate.

To solve these problems, an inkjet method has been focused on as an alternative method for forming an identification code. In the inkjet method, droplets of liquid containing metal particles are ejected from a nozzle. The droplets are then dried and thus form dots. The inkjet method is applicable to a wider variety of substrates and prevents contamination of the substrates caused by formation of the identification codes.

However, when drying droplets on a substrate, the inkjet method may have the following problem caused by the surface condition of the substrate or the surface tension of each droplet. Specifically, after having been received by the surface of the substrate, the droplet may spread on the substrate surface as the time elapses. Therefore, if the time necessary for drying the droplet exceeds a predetermined level (for example, 100 milliseconds), the droplet may spread beyond the corresponding data cell and reaches an adjacent data cell. This may lead to erroneous formation of the code pattern.

This problem may be avoided by radiating an energy beam (for example, a laser beam) onto a droplet on the substrate at a predetermined point of time and solidifying the droplet.

However, in this case, volatile elements or mist evaporated from the droplet may adhere to an optical component, contaminating the optical path of the energy beam. This destabilizes the radiation amount or the radiating position of the energy beam, varying the shape of the obtained pattern.

US 2004/0113971 Al relates to an ink jet recording apparatus. The apparatus includes an UV ink jet recording head fitted with a nozzle to eject UV ink, a capping member to cap an ejection plane of a nozzle, a cleaning member which comes into contact with the ejection plane of the nozzle to clean the ejection plane of the nozzle, a piping member to supply a UV ink to the UV ink jet recording or discharge the UV ink and an ink tank member to supply the UV ink to the UV ink jet recording head or store discharge ink.

### SUMMARY

Accordingly, it is an objective of the present invention to provide a liquid ejection apparatus that stabilizes the optical characteristics of energy beams radiated onto droplets of liquid and thus improves controllability for shaping a pattern formed by the droplets.

In accordance with one aspect of the present invention, a liquid ejection apparatus including a liquid ejection section, an energy beam radiating section, and a cleaning section is provided. The liquid ejecting section ejects a droplet onto an object. The energy beam radiating section radiates an energy beam onto the droplet on the object. The energy beam radiating section has an optical component that defines a radiation path of the energy beam. The cleaning section cleans the optical component of the energy beam radiating section.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:

Fig. 1 is a plan view showing a liquid crystal display having an identification code formed by a liquid ejection apparatus according to a first embodiment of the present invention;

Fig. 2 is a perspective view schematically showing the liquid ejection apparatus of the first embodiment;

Fig. 3 is a plan view schematically showing the liquid ejection apparatus of the first embodiment;

Fig. 4 is a view for explaining a head unit;

Fig. 5 is a view for explaining a cleaning mechanism of the first embodiment;

Fig. 6 is a view for explaining the cleaning mechanism;

Fig. 7 is a block diagram representing the electric circuit of the liquid ejection apparatus;

Fig. 8 is a view for explaining a cleaning mechanism according to a second embodiment of the present invention; and

Fig. 9 is a view for explaining a cleaning mechanism of a modification.

### DESCRIPTION OF EXEMPLARY EMBODIMENTS

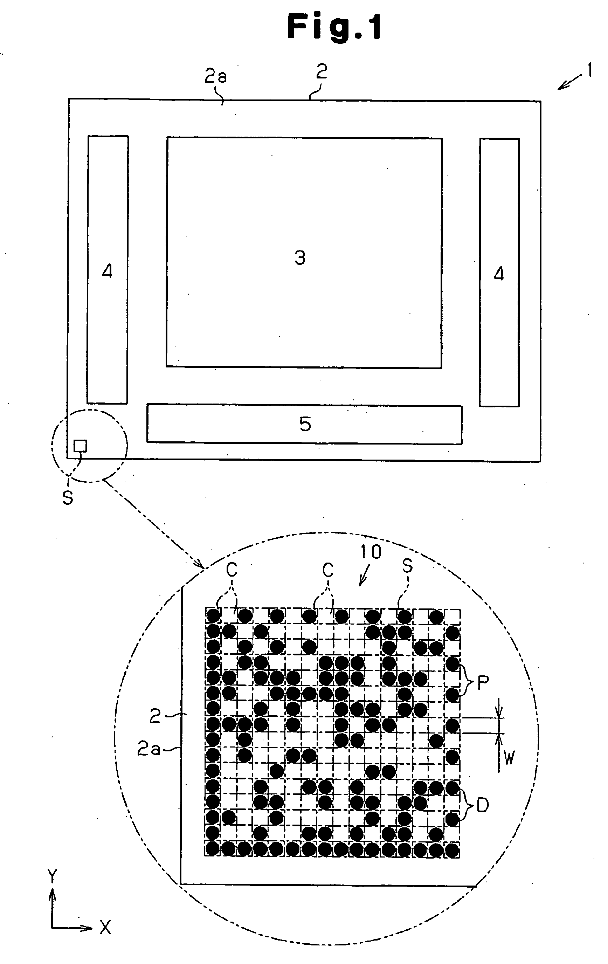

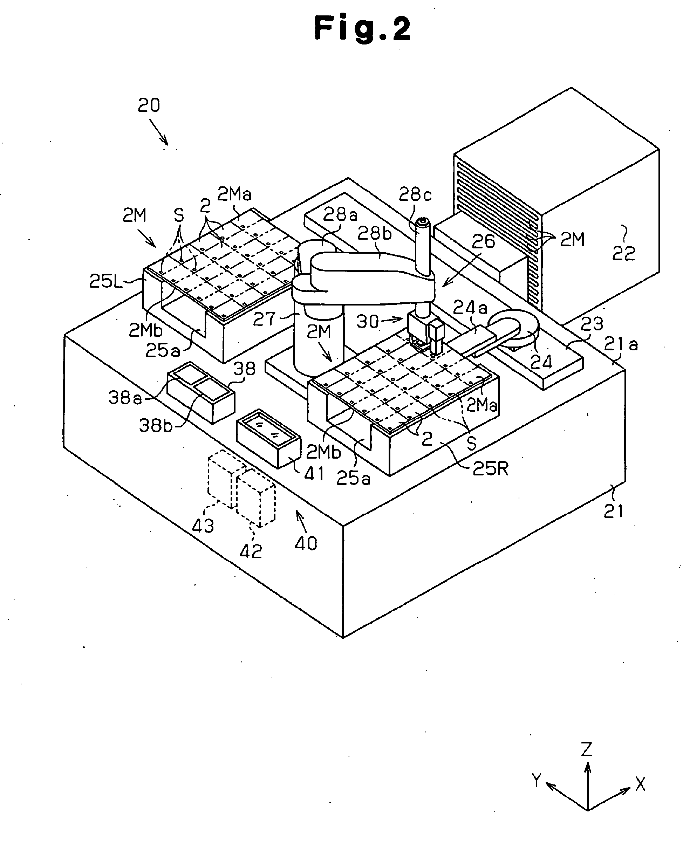

A liquid crystal display having an identification code formed by a method for forming a pattern according to the present invention will now be described with reference to Figs. 1 to 5. In the following, direction X, direction Y, and direction Z will be defined as illustrated in Fig. 2. First, a liquid crystal display 1 having an identification code formed by a liquid ejection apparatus of the present invention will be explained.

As shown in Fig. 1, a liquid crystal display 1 has a rectangular glass substrate (hereinafter, refereed to as a substrate) 2. A rectangular display portion 3 is formed substantially at the center of a surface 2a of the substrate 2. Liquid crystal molecules are sealed in the display portion 3. A scanning line driver circuit 4 and a data line driver circuit 5 are provided outside the display portion 3. In the liquid crystal display 1, the orientation of the liquid crystal molecules is adjusted in correspondence with a scanning signal generated by the scanning line driver circuit 4 and a data signal produced by the data line driver circuit 5. In accordance with the orientation of the liquid crystal molecules, area light radiated by an illumination device (not shown) is modulated to display an image on the display portion 3 of the substrate 2.

An identification code 10 indicating the product number or the lot number of the liquid crystal display 1 is formed at the left corner of the surface 2a of the substrate 2. The identification code 10 is formed by a plurality of dots D and provided in a code formation area S in accordance with a prescribed pattern. The code formation area S includes 256 data cells, aligned by 16 lines and 16 rows. Each of the data cells C is defined by virtually dividing the code formation area S, which has a square shape of 1 mm x 1 mm, into equally sized sections. The dots D are formed in selected ones of the data cells C, thus forming the identification code 10.

In the first embodiment, the center of each of the data cells C in which a dot D is formed will be referred to as an "ejection target position P" and the length of each side of each data cell C will be refereed to as a "cell width W".

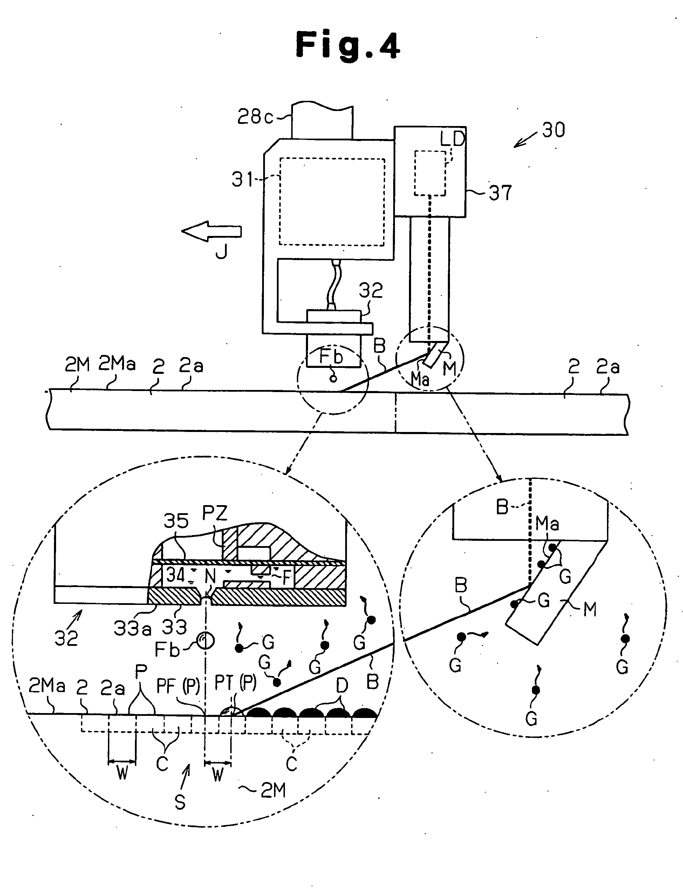

Each of the dots D is formed in a semispherical shape with an outer diameter equal to the cell width W. To form the dots D, droplets Fb of liquid containing metal particles (for example, nickel particles or manganese particles) as pattern forming material are ejected onto the corresponding cells C (the black cells C1). The droplets Fb in the cells C are then irradiated with laser beams, which dry and bake the droplets Fb (see Fig. 4), forming the dots D. Alternatively, the dots D may be formed simply by drying the droplets Fb through radiation of a laser beam.

A liquid ejection apparatus 20 for forming the identification code 10 will hereafter be described. In the following case, a plurality of identification codes 10 will be formed on a mother substrate 2M, or an object from which a plurality of substrates 2 are cut out.

As shown in Fig. 2, the liquid ejection apparatus 20 has a substantially parallelepiped base 21. A substrate stocker 22 that accommodates a plurality of mother substrates 2M is provided at the right-hand side of the base 21. The substrate stocker 22 is movable in the direction defined by the height of the substrate stocker 22 (in direction Z and the direction opposite to direction Z). Each of the mother substrates 2M is retrieved from the substrate stocker 22 and transported to the base 21. The mother substrate 2M is later removed from the base 21 and returned to the corresponding one of slots defined in the substrate stocker 22.

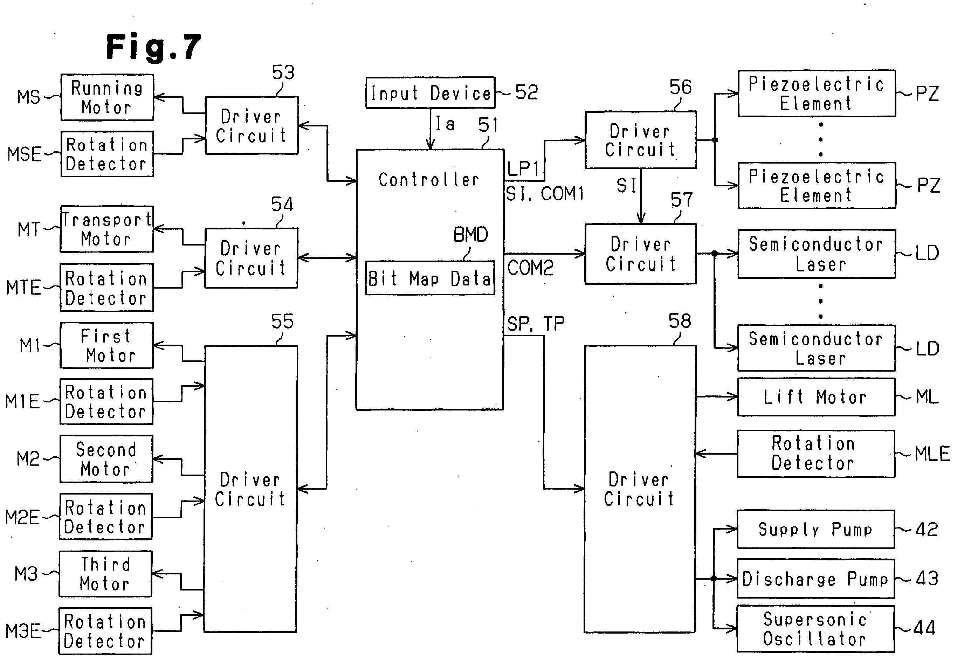

A running device 23, which extends in direction Y, is arranged on an upper surface 21a of the base 21 and in the vicinity of the substrate stocker 22. The running device 23 is operably connected to the output shaft of a running motor MS (see Fig. 7). A transport device 24, which runs in direction Y and the direction opposite to direction Y, is mounted on the running device 23. The transport device 24 has a transport arm 24a, which draws by suction and holds a backside 2Mb of the mother substrate 2M. The transport device 24 is operably connected to the output shaft of a transport motor MT (see Fig. 7). The transport device 24 is a SCARA robot movable in the direction defined by the height of the transport device 24. The transport device 24 supports the transport arm 24a in such a manner as to allow the transport arm 24a to extend, contract, or pivot on the X-Y plane.

A pair of mounting tables 25R, 25L are arranged on the upper surface 21a of the base 21 and in the vicinity of opposing sides of the base 21. One of the mother substrates 2M is mounted on each of the mounting tables 25R, 25L with the surface 2Ma of the mother substrate 2M facing upward. Each mounting table 25R, 25L has a recess 25a having an upper opening. The transport arm 24a moves in the recess 25a of the corresponding one of the mounting tables 25R, 25L in a horizontal direction and the direction defined by the height of the transport arm 24a. In this manner, the mother substrate 2M is transported to and placed on the mounting table 25R, 25L.

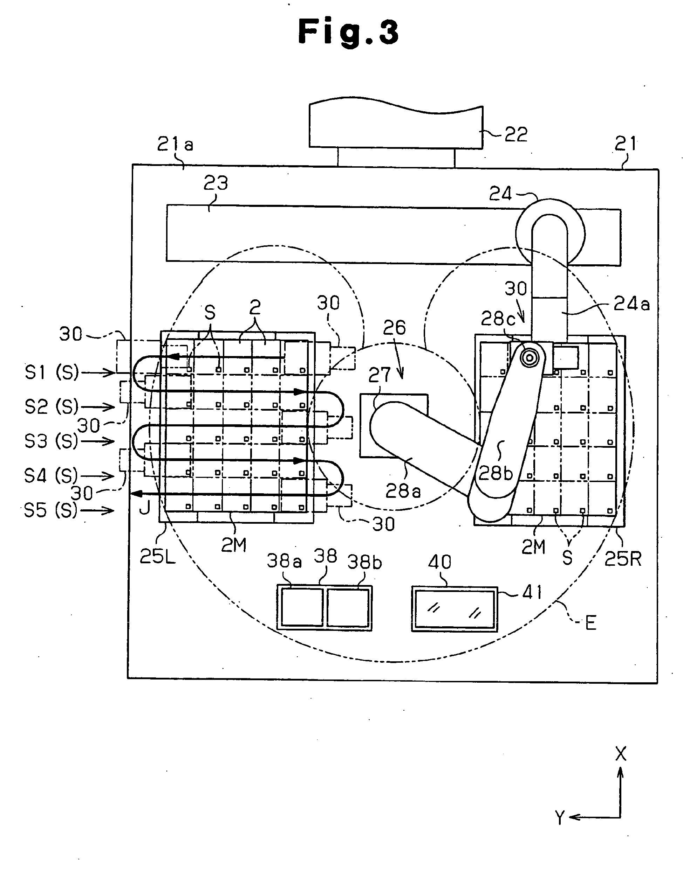

When a drive signal is sent to the running motor MS and the transport motor MT, the running device 23 and the transport device 24 (the transport arm 24a) are operated. In this manner, the corresponding one of the mother substrates 2M is thus retrieved from the substrate stocker 22 and placed on the corresponding one of the mounting tables 25R, 25L. The mother substrate 2M is also returned from the mounting table 25R, 25L to the corresponding slot of the substrate stocker 22. A code areas S is defined on the mother substrates 2M mounted on the mounting tables 25R, 25L. In each of the mother substrates 2M, the rows of the code areas S are defined as the first row of the code areas S1, the second row of the code areas S2, the third row of the code areas S3, the fourth row of the code areas S4, and the fifth row of the code areas S5 sequentially from the foremost row of the code areas S to the rearmost row of the code areas S (see Fig. 3).

A multi-joint robot (hereinafter, referred to as a SCARA robot) 26 is arranged between the two mounting tables 25R, 25L on the upper surface 21a of the base 21. The SCARA robot 26 has a main shaft 27 that extends upward (in direction Z) from the upper surface 21a of the base 21. A first arm 28a is pivotally connected to an upper end of the main shaft 27. A second arm 28b is pivotally connected to the distal end of the first arm 28a. A columnar third arm 28c is connected to the distal end of the second arm 28b in a manner rotatable about the axis of the third arm 28c. A head unit 30 is formed at a lower end of the third arm 28c.

The first arm 28a, the second arm 28b, and the third arm 28c are operably connected to the output shaft of a first motor M1, the output shaft of a second motor M2, and the output shaft of a third motor M3, respectively (see Fig. 7). When a drive signal is provided to any one of the first, second, and third motors M1, M2, M3, the SCARA robot 26 operates the corresponding one of the first, second, and third arms 28a, 28b, 28c to move the head unit 30 in a predetermined scanning area (the area indicated by the double-dotted chain lines of Fig. 3) on the base 21.

As shown by the corresponding arrow of Fig. 3, the SCARA robot 26 first rotates the first, second, and third arms 28a, 28b, 28c to move the head unit 30 in direction Y along the first row of the code areas S1. After scanning the first row of the code areas S, the SCARA robot 26 rotates the third arm 28c to rotate the head unit 30 counterclockwise at 180 degrees. The SCARA robot 26 then re-rotates the first, second, and third arms 28a, 28b, 28c to move the head unit 30 in the direction opposite to direction Y along the second row of the code areas S2.

Afterwards, the SCARA robot 26 moves the head unit 30 in direction Y or the direction opposite to direction Y along the third, fourth, and fifth rows of the code areas S3, S4, S5 in this order. In this manner, while changing the orientation and the movement direction of the head unit 30 (the scanning direction J), the SCARA robot 26 moves the head unit 30 along the path defined by connecting the code areas S together.

Referring to Fig. 4, a box-like liquid tank 31, which retains liquid F, is provided in the head unit 30. The liquid F is drawn from the liquid tank 31 to a liquid ejection head 32, which forms a liquid ejecting section.

The liquid ejection head 32 (hereinafter, referred to simply as the "ejection head 32") is provided in a lower portion of the head unit 30. A nozzle plate 33 is formed on a lower side of the ejection head 32. A plurality of nozzles N are defined in a lower surface (a nozzle surface) 33a of the nozzle plate 33. Each of the nozzles N is a circular bore extending in a normal direction of the mother substrate 2M. The nozzles N are aligned in a direction perpendicular to the scanning direction J of the head unit 30. The pitch of the nozzles N is equal to the cell width W. In the following description, a position immediately below each nozzle N on the surface 2Ma of the mother substrate 2M will be referred to as a droplet receiving position PF.

Referring to Fig. 4, cavities 34 are defined in the liquid tank 31 and communicate with the corresponding nozzles N. An oscillation plate 35 is provided on each of the cavities 34 and oscillates in the direction defined by the height of the oscillation plate 35. Through oscillation of the corresponding oscillation plate 35, the volume of each cavity 34 increases and decreases. A plurality of piezoelectric elements PZ are formed on the upper surfaces of the oscillation plates 35 in correspondence with the nozzles N. Each of the piezoelectric elements PZ contracts and extends in response to a drive signal (drive voltage COM1: see Fig. 7). This oscillates the corresponding one of the oscillation plates 35 in the direction defined by the height of the oscillation plate 35. The liquid F is thus supplied from the liquid tank 31 to the associated one of the nozzles N, ejecting a droplet Fb from the nozzle N. More specifically, when the droplet receiving positions PF coincide with the ejection target positions P of the corresponding code areas S through operation of the SCARA robot 26, the drive voltage COM1 is supplied to the piezoelectric elements PZ to eject the droplets Fb from the associated nozzles N. After having reached the corresponding one of the ejection target positions P, each of the droplets Fb spreads on the surface 2Ma of the mother substrate 2M and develops until the outer diameter of the droplet Fb becomes equal to the size (the cell width W) at which the droplet Fb should be dried.

In the first embodiment, the time from when the droplets Fb are ejected from the nozzles N to when the outer diameter of each droplet Fb becomes equal to the cell width W will be referred to as "radiation standby time". The head unit 30 moves by the distance corresponding to the cell width W in the radiation standby time.

A laser head 37, or an energy beam radiating section, is formed in an upper portion of the head unit 30. A plurality of semiconductor lasers LD are provided in the laser head 37 in correspondence with the nozzles N. The semiconductor lasers LD are aligned in the direction in which the nozzles N are aligned. Each of the semiconductor lasers LD radiates a laser beam B in response to a drive signal (drive voltage COM2: see Fig. 7). The laser beam B has an energy in the wavelength range corresponding to the absorption wavelength of each droplet Fb.

A plurality of reflective mirrors M, each of which forms an optical system, extend from a lower end of the laser head 37 in correspondence with the semiconductor lasers LD. Each of the reflective mirrors M is located immediately below the corresponding one of the semiconductor lasers LD. The reflective mirrors M are aligned in the direction in which the nozzles N are aligned. The surface of each reflective mirror M opposed to the corresponding semiconductor laser LD is a reflective surface Ma (an optical surface). The reflective surface Ma totally reflects the laser beam B radiated by the semiconductor laser LD, thus leading the laser beam B to the corresponding radiating position PT on the substrate 2.

In the first embodiment, the droplet receiving positions PF and the radiating positions PT are defined on the movement path of the head unit 30. The distance between each droplet receiving position PF and the corresponding radiating position PT is equal to the distance covered by movement of the head unit 30 in the radiation standby time (the cell width W).

When the radiating positions PT coincide with the corresponding ejection target positions P through operation of the SCARA robot 26, the drive voltage COM2 is supplied to the semiconductor lasers LD, causing the semiconductor lasers LD to radiate the laser beams B. Each laser beam B is totally reflected by the reflective surface Ma of the corresponding reflective mirror M and then radiated onto the droplet Fb at the corresponding radiating position PT. The laser beam B evaporates solvent and dispersion medium from the droplet Fb and bakes the metal particles in the droplet Fb. As a result, a semispherical dot D having an outer diameter equal to the cell width W is formed at the ejection target position P on the substrate 2.

The elements evaporated from the droplets Fb float upward from the mother substrate 2M and adhere to the ejection head 32 and the reflective mirrors M of the head unit 30, forming adhered matter G. The adhered matter G contaminates the reflective surfaces Ma of the reflective mirrors M and the nozzle surface 33a of the ejection head 32.

To solve this problem, as shown in Figs. 2 and 3, a maintenance mechanism 38 for the ejection head 32 and a cleaning mechanism 40 (a cleaning section) that cleans the head unit 30 are provided on the upper surface 21a of the base 21. The maintenance mechanism 38 has a suction pump 38a and a wiping sheet 38b. To stabilize ejection of the droplets Fb, the maintenance mechanism 38 draws and drains the liquid F with high viscosity from the ejection head 32 by the suction pump 38a. Further, the wiping sheet 38b wipes the liquid F off from the ejection head 32.

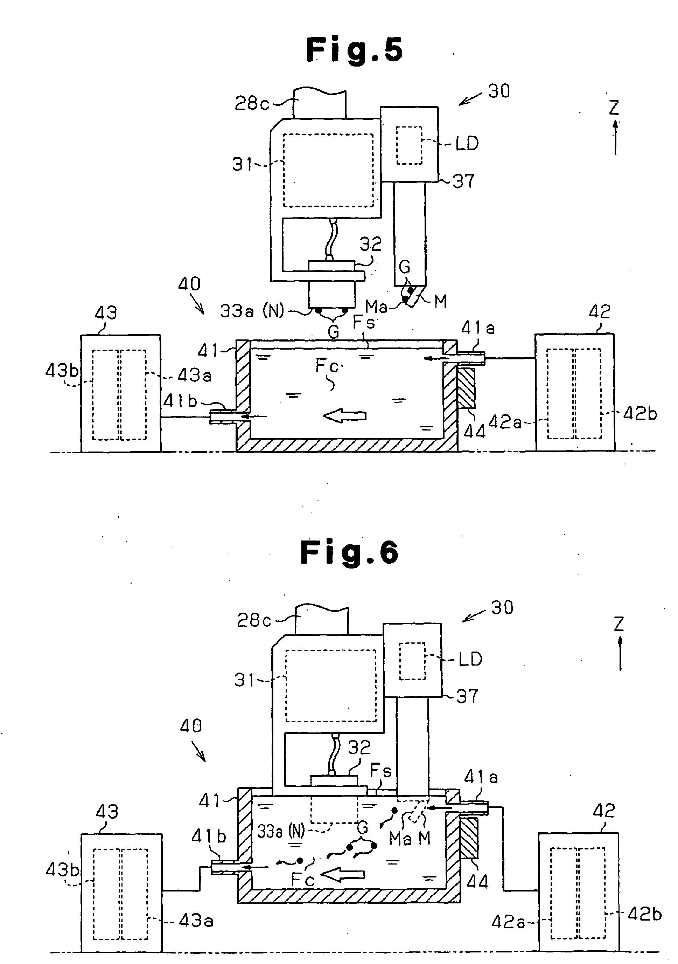

The cleaning mechanism 40 has a box-like cleaning bath 41 with an upper opening, or a cleaning liquid supply section. The cleaning bath 41 is operably connected to a lift motor ML (see Fig. 7). The cleaning bath 41 is raised and lowered with respect to the upper surface 21a of the base 21. Through actuation of the lift motor ML, the cleaning bath 41 moves between the standby position of Fig. 5 and the cleaning position of Fig. 6.

As shown in Fig. 5, an inlet pipe 41a (an inlet section) is formed in an upper portion of the cleaning bath 41. The cleaning bath 41 is connected to a cleaning liquid supply section 42 through the inlet pipe 41a. The cleaning liquid supply section 42 has a supply tank 42a and a supply pump 42b. The supply tank 42a retains cleaning liquid Fc that washes the adhered matter G off from the nozzle surface 33a and the reflective surfaces Ma. The supply pump 42b pressurizes the cleaning liquid Fc and supplies the cleaning liquid Fc to the cleaning bath 41. The cleaning liquid Fc and the liquid F exhibit mutual solubility.

An outlet pipe 41b (an outlet section) is formed in a lower portion of the cleaning bath 41 at the side opposed to the inlet pipe 41a. The cleaning bath 41 is connected to a cleaning liquid discharge section 43 through the outlet pipe 41b. The cleaning liquid discharge section 43 has a liquid waste tank 43a and a discharge pump 43b. The liquid waste tank 43a retains the used cleaning liquid Fc. The discharge pump 43b drains the cleaning liquid Fc from the cleaning bath 41 into the liquid waste tank 43a.

When a drive signal is input to the supply pump 42b and the discharge pump 43b, a predetermined amount of the cleaning liquid Fc is supplied from the cleaning liquid supply section 42 to the cleaning bath 41 through the inlet pipe 41a and the same amount of the cleaning liquid Fc is drained to the liquid waste tank 43a through the outlet pipe 41b. In other words, the cleaning liquid supply section 42 and the cleaning liquid discharge section 43 operate to move the cleaning liquid Fc in the cleaning bath 41 from the inlet pipe 41a to the outlet pipe 41b, causing replacement of the cleaning liquid Fc in the cleaning bath 41. In this state, the liquid level Fs of the cleaning liquid Fc in the cleaning bath 41 is maintained constant.

Through operation of the SCARA robot 26, the head unit 30 is arranged immediately above the cleaning mechanism 40 (the cleaning bath 41) with the laser head 37 (the reflective mirrors M) located at a side of the ejection head 32 that faces the inlet pipe 41a.

In the first embodiment, when the cleaning bath 41 is located at the standby position of Fig. 5, the ejection head 32 and the reflective mirrors M are raised from the cleaning liquid Fc. When the cleaning bath 41 is located at the cleaning position of Fig. 6, the nozzle surface 33a of the ejection head 32 and the reflective surfaces Ma of the reflective mirrors M are immersed in the cleaning liquid Fc.

A supersonic oscillator 44, or an oscillating section, is secured to the cleaning bath 41. The supersonic oscillator 44 causes supersonic oscillation of the cleaning liquid Fc in the cleaning bath 41.

When the cleaning bath 41 is arranged at the standby position, the SCARA robot 26 operates to move the head unit 30 to a position immediately above the cleaning mechanism 40 (the cleaning bath 41). In this manner, referring to Fig. 5, the laser head 37 is (the reflective mirrors M are) arranged at a side of the ejection head 32 that faces the inlet pipe 41a. In this state, the lift motor ML is actuated to move the cleaning bath 41 to the cleaning position. As a result, as illustrated in Fig. 6, the nozzle surface 33a of the ejection head 32 and the reflective surfaces Ma of the reflective mirrors M are immersed in the cleaning liquid Fc in the cleaning bath 41.

In this state, the supply pump 42b, the discharge pump 43b, and the supersonic oscillator 44 are activated to cause supersonic oscillation of the cleaning liquid Fc in the cleaning bath 41, thus washing the adhered matter G off the nozzle surface 33a and the reflective surfaces Ma. Further, since the adhered matter G in a dissolved state flows from the vicinity of the inlet pipe 41a toward the outlet pipe 41b, the adhered matter G is drained into the liquid waste tank 43a through the outlet pipe 41b.

In this manner, by removing the adhered matter G from the nozzle surface 33a and the reflective surfaces Ma, ejection of the droplets Fb by the ejection head 32 and radiation of the laser beams B by the laser head 37 are stabilized. Further, while the cleaning liquid Fc flows from the vicinity of the inlet pipe 41a to the outlet pipe 41b, the reflective mirrors M (the reflective surfaces Ma) are maintained constantly upstream from the nozzle surface 33a (the nozzles N). This prevents the liquid F dissolved from the nozzles N into the cleaning liquid Fc from adhering to the reflective surfaces Ma of the reflective mirrors M.

Further, in the first embodiment, a non-illustrated air supply device blasts dry air onto the nozzle surface 33a and the reflective mirrors M after the nozzle surface 33a and the reflective mirrors M have been raised from the cleaning liquid Fc. The cleaning liquid Fc is thus removed from the nozzle surface 33a and the reflective mirrors M.

The electric circuit of the liquid ejection apparatus 20 will be explained in the following, with reference to Fig. 7.

As illustrated in Fig. 7, a controller 51 has a CPU, a RAM, and a ROM. In accordance with various types of data and different control programs stored in the ROM, the controller 51 operates the running device 23, the transport device 24, and the SCARA robot 26 while activating the ejection head 32, the laser head 37, and the cleaning mechanism 40.

An input device 52 having a start switch and a stop switch is connected to the controller 51. Through manipulation of the switches by the operator, an image of the identification code 10 is input to the controller 51 as a prescribed form of imaging data Ia. In accordance with the imaging data Ia, the controller 51 generates bit map data BMD and the drive voltages COM1, COM2.

The bit map data BMD is data that indicates whether to turn on or off the piezoelectric elements PZ in accordance with the value of each bit (0 or 1). That is, the bit map data BMD instructs whether or not to eject the droplets Fb onto the data cells C defined on a two-dimensional imaging plane (the surface 2Ma of the corresponding mother substrate 2M).

A driver circuit 53 of the running device 23 is connected to the controller 51. The running motor MS and a rotation detector MSE are connected to the driver circuit 53. The rotation detector MSE outputs a prescribed signal when rotation of the running motor MS is detected. The controller 51 sends a drive signal to the driver circuit 53 to drive the running motor MS. In response to the drive signal of the controller 51, the driver circuit 53 rotates the running motor MS in a forward direction or a reverse direction. The controller 51 also computes the movement direction and the movement amount of the transport device 24 in correspondence with the detection signal of the rotation detector MSE.

A driver circuit 54 of the transport device 24 is connected to the controller 51. The driver circuit 54 has the transport motor MT and a rotation detector MTE. The rotation detector MTE outputs a prescribed signal when rotation of the transport motor MT is detected. In response to a drive signal of the controller 51, the driver circuit 54 rotates the transport motor MT in a forward direction or a reverse direction. Further, in correspondence with the detection signal of the rotation detector MTE, the driver circuit 54 calculates the movement direction and the movement amount of the transport arm 24a.

A driver circuit 55 of the SCARA robot 26 is connected to the controller 51. The first motor M1, the second motor M2, and the third motor M3 are connected to the driver circuit 55. In response to a drive signal of the controller 51, the driver circuit 55 rotates the first, second, and third motors M1, M2, M3 in a forward direction or a reverse direction. Rotation detectors M1E, M2E, M3E are connected to the driver circuit 55. In correspondence with detection signals of the rotation detectors M1E, M2E, M3E, the driver circuit 55 computes the movement direction and the movement amount of the head unit 30.

The controller 51 moves the head unit 30 in the scanning direction J through the driver circuit 55 and provides different types of control signals to the corresponding driver circuits in correspondence with the computation results obtained by the driver circuit 55.

More specifically, in correspondence with the timing at which the droplet receiving positions PF, which move together with the head unit 30, coincide with the corresponding ejection target positions P on the mother substrate 2M, the controller 51 outputs an ejection timing signal LP1 to the driver circuit 56. Also, in correspondence with the timing at which the head unit 30 reaches the position immediately above the cleaning bath 41, the controller 51 sends a cleaning start signal SP to the driver circuit 58.

A driver circuit 56 is connected to the controller 51. The controller 51 sends the ejection timing signal LP1 to the driver circuit 56. Further, the controller 51 provides the drive voltage COM1 to the driver circuit 56 synchronously with a prescribed reference clock signal. The controller 51 also generates ejection control signals SI from the bit map data BMD synchronously with a prescribed reference clock signal. The ejection control signals SI are serially transferred to the driver circuit 56 of the ejection head 32. The driver circuit 56 sequentially converts the serial ejection control signals SI to parallel signals in correspondence with the piezoelectric elements PZ.

When receiving the ejection timing signal LP1 from the controller 51, the driver circuit 56 supplies the drive voltage COM1 to the piezoelectric elements PZ that are selected in accordance with the ejection control signals SI. In other words, the controller 51 operates to eject the droplets Fb from the nozzles N corresponding to the bit map data BMD when the receiving positions PF coincide with the corresponding ejection target positions P. The controller 51 operates the driver circuit 56 to send the parallel ejection control signals SI, which have been converted from the serial forms, to a driver circuit 57 of the laser head 37.

The driver circuit 57 is connected to the controller 51. The controller 51 supplies the drive voltage COM2 synchronized with a prescribed reference clock signal to the driver circuit 57.

After the radiation standby time has elapsed since reception of the ejection control signals SI from the driver circuit 56, the driver circuit 57 supplies the drive voltage COM2 to the semiconductor lasers LD corresponding to the ejection control signals SI. Specifically, the controller 51 operates in such a manner that the head unit 30 moves (the reflective mirrors M move) to cover the distance corresponding to the radiation standby time and then radiates the laser beams B onto the droplets Fb at the ejection target positions P when the radiating positions PT coincide with the ejection target positions P.

A driver circuit 58 of the cleaning mechanism 40 is connected to the controller 51. The controller 51 sends the cleaning start signal SP and a cleaning stop signal TP to the driver circuit 58. The lift motor ML is connected to the driver circuit 58. In response to the cleaning start signal SP or the cleaning stop signal TP of the controller 51, the driver circuit 58 rotates the lift motor ML in a forward direction or a reverse direction to raise or lower the cleaning bath 41. A rotation detector MLE is connected to the driver circuit 58 and outputs a prescribed signal when rotation of the lift motor ML is detected. The driver circuit 58 calculates the movement direction and the movement amount of the cleaning bath 41 in correspondence with the detection signal of the rotation detector MLE.

When receiving the cleaning start signal SP from the controller 51, the driver circuit 58 rotates the lift motor ML in the forward direction to move the cleaning bath 41 to the cleaning position. Further, the driver circuit 58 determines whether the cleaning bath 41 has reached the cleaning position in correspondence with the detection signal of the rotation detector MLE. When the cleaning bath 41 reaches the cleaning position, the driver circuit 58 activates the supersonic oscillator 44 to cause supersonic oscillation of the cleaning liquid Fc in the cleaning bath 41. The driver circuit 58 also operates the supply pump 42b and the discharge pump 43b to start introduction of the cleaning liquid Fc into the cleaning bath 41 and drainage of the cleaning liquid Fc from the cleaning bath 41.

When receiving the cleaning stop signal TP from the controller 51, the driver circuit 58 rotates the lift motor ML in the reverse direction so as to return the cleaning bath 41 to the standby position. The driver circuit 58 determines whether the cleaning bath 41 has reached the standby position in correspondence with the detection signal of the rotation detector MLE. When the cleaning bath 41 reaches the standby position, the driver circuit 58 deactivates the supply pump 42b, the discharge pump 43b, and the supersonic oscillator 44.

A method for forming the identification code 10 by the liquid ejection apparatus 20 will hereafter be explained.

First, the input device 52 is manipulated by the operator to provide the imaging data Ia to the controller 51. The controller 51 then drives the running device 23 and the transport device 24 through the driver circuit 53 and the driver circuit 54, respectively, to transport the corresponding mother substrate 2M from the substrate stocker 22 and place the mother substrate 2M on the mounting table 25R (the mounting table 25L).

Further, the controller 51 generates the bit map data BMD from the imaging data Ia and produces the drive voltages COM1, COM2. The controller 51 then operates the SCARA robot 26 through the driver circuit 55, starting movement of the head unit 30. In correspondence with the computation results of the driver circuit 55, the controller 51 determines whether the droplet receiving positions PF coincide with the rearmost ones of the data cells C in the first rows of the code areas S1 in direction Y (the ejection target positions P).

Meanwhile, the controller 51 sends the ejection control signals SI and the drive voltage COM1 to the driver circuit 56 and the drive voltage COM2 to the driver circuit 57.

When the droplet receiving positions PF coincide with the data cells C rearmost in the first row of the code areas S1 in direction Y (the ejection target positions P), the controller 51 outputs the ejection timing signal LP1 to the driver circuit 56 and supplies the drive voltage COM1 to the piezoelectric elements PZ selected in accordance with the ejection control signals SI. The droplets Fb are thus simultaneously ejected from the selected ones of the nozzles N. After having reached the corresponding ejection target position P, each droplet Fb spreads on the surface 2a of the substrate 2. By the time the radiation standby time elapses since starting of ejection of the droplets Fb, the outer diameter of each droplet Fb becomes equal to the cell width W.

Further, the controller 51 sends the parallel ejection control signals SI, which have been converted from the serial forms, to the driver circuit 57 through the driver circuit 56. After the radiation standby time has elapsed since starting of ejection, the controller 51 supplies the drive voltage COM2 to the semiconductor lasers LD selected in accordance with the ejection control signals SI. As a result, the selected semiconductor lasers LD simultaneously radiate the laser beams B.

The laser beams B are then totally reflected by the reflective surfaces Ma of the reflective mirrors M and radiated onto the droplets Fb at the radiating positions PT (the ejection target positions P). This evaporates the solvent or the dispersion medium from the droplets Fb and bakes the metal particles of the droplets Fb. As a result, the dots D having an outer diameter equal to the cell width W are provided on the surface 2Ma of the mother substrate 2M.

Afterwards, the controller 51 continuously moves the head unit 30 along the scanning path in the same manner as has been described. Each time the droplet receiving positions PF coincide with the ejection target positions P, the controller 51 operates to eject the droplets Fb from the selected nozzles N. Further, the laser beams B are radiated onto the droplets Fb when the outer diameter of each droplet Fb becomes equal to the cell width W. After having formed all of the dots D, the controller 51 operates the running device 23 and the transport device 24 to return the mother substrate 2M from the mounting table 25R (the mounting table 25L) to the substrate stocker 22.

During formation of the dots D, the adhered matter G deposits on the reflective surfaces Ma of the reflective mirrors M and the nozzle surface 33a of the ejection head 32. This gradually degrades the optical characteristics of the laser beams B radiated by the laser head 37 and ejection performance of the droplets Fb by the ejection head 32.

In the first embodiment, after the mother substrate 2M is received in the substrate stocker 22, the controller 51 first operates the SCARA robot 26 through the driver circuit 55 to move the head unit 30 to the position immediately above the cleaning bath 41. The controller 51 then sends the cleaning start signal SP to the driver circuit 58 so as to move the cleaning bath 41 to the cleaning position. At this position, the nozzle surface 33a of the ejection head 32 and the reflective surfaces Ma of the reflective mirrors M are immersed in the cleaning liquid Fc. In this state, the controller 51 actuates the supersonic oscillator 44 through the driver circuit 58, causing supersonic oscillation of the cleaning liquid Fc in the cleaning bath 41. Further, the controller 51 operates the supply pump 42b and the discharge pump 43b to start introduction of the cleaning liquid Fc into the cleaning bath 41 and drainage of the cleaning liquid Fc from the cleaning bath 41.

As a result, the adhered matter G deposited on the nozzle surface 33a and the reflective surfaces Ma is dissolved into the cleaning liquid Fc. The adhered matter G is thus discharged from the cleaning bath 41 into the liquid waste tank 43a together with the cleaning liquid Fc. Since the nozzle surface 33a and the reflective surfaces Ma are cleaned in this manner, the initial states of the ejection performance of the ejection head 32 and the optical characteristics of the laser head 37 (the laser beams B) are restored.

After having cleaned the nozzle surface 33a and the reflective surfaces Ma for a predetermined time, the controller 51 outputs the cleaning stop signal TP to the driver circuit 58. The cleaning bath 41 is thus returned to the standby position and the supply pump 42b, the discharge pump 43b, and the supersonic oscillator 44 are deactivated. Subsequently, the controller 51 operates the non-illustrated air supply device to blast the dry air onto the nozzle surface 33a and the reflective mirrors M, thus drying and removing the cleaning liquid Fc.

The first embodiment has the following advantages.

(1) Since the adhered matter G is removed also from the nozzle surface 33a, the droplets Fb are ejected stably by the ejection head 32. This further enhances the controllability for shaping the dots D.

(2) The cleaning liquid supply section 42 and the cleaning liquid discharge section 43 are connected to the cleaning bath 41. The cleaning liquid supply section 42 introduces the cleaning liquid Fc into the cleaning bath 41 and the cleaning liquid discharge section 43 discharges the cleaning liquid Fc from the cleaning bath 41. Therefore, the adhered matter G on the reflective surfaces Ma and the nozzle surface 33a is dissolved into the cleaning liquid Fc and then drained from the cleaning bath 41 together with the cleaning liquid Fc. This maintains the cleaning performance of the cleaning mechanism 40. The optical characteristics of the laser beams B are thus maintained stable for a relatively long time.

(3) The reflective mirrors M are immersed in the cleaning liquid Fc in the vicinity of the inlet pipe 41a and the ejection head 32 is immersed in the cleaning liquid Fc in the vicinity of the outlet pipe 41b. Therefore, the reflective mirrors M (the reflective surfaces Ma) are maintained upstream from the nozzle surface 33a (the nozzles N). This prevents the liquid F dissolved from the nozzles N into the cleaning liquid Fc from adhering to the reflective surfaces Ma.

(4) The cleaning bath 41 has the supersonic oscillator 44 that causes supersonic oscillation of the cleaning liquid Fc. The reflective mirrors M and the nozzle surface 33a are thus further effectively cleaned.

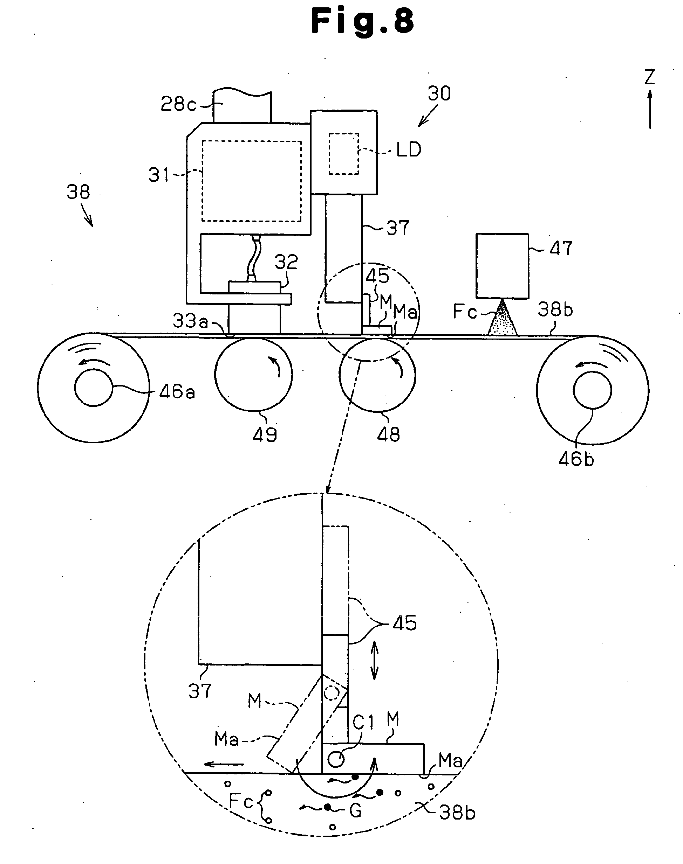

A second embodiment of the present invention will now be described with reference to Fig. 8. Same or like reference numerals are given to parts of the second embodiment that are the same as or like corresponding parts of the first embodiment and detailed description thereof will be omitted. In the following description of the second embodiment, the configuration of a maintenance mechanism 38 of the ejection head 32 will be explained in detail.

As shown in Fig. 8, a plate-like mirror securing section 45 is supported by a lower end of the laser head 37 in a manner movable in the direction defined by the height of the mirror securing section 45. The reflective mirrors M of the first embodiment are pivotally secured to a lower end of the mirror securing section 45. In the second embodiment, the mirror securing section 45 moves downward from the state in which the laser beams B are radiated (the state indicated by the double-dotted chain lines of Fig. 8). The reflective surfaces M1 of the reflective mirrors M pivot counterclockwise about the axis C1 (in the direction indicated by the corresponding arrow of Fig. 8). The reflective surfaces Ma of the reflective mirrors M thus face downward and are located substantially on the same plane as the nozzle surface 33a.

Hereinafter, the position of each reflective mirror M at which the laser beams B are radiated onto the radiating positions PT (see Fig. 4) will be referred to as the mirror reflecting position. The position of the reflective mirror M at which the reflective mirror M is located on the same plane as the nozzle surface 33a will be referred to as the mirror cleaning position.

The maintenance mechanism 38 has a drive roller 46a that rotates counterclockwise and a driven roller 46b. A wiping sheet 38b, or a wiping member forming the cleaning liquid supply section, is wound around the outer circumference of the driven roller 46b. When the drive roller 46a rotates, the wiping sheet 38b is continuously reeled off the driven roller 46b and wound around the outer circumference of the drive roller 46a.

When the head unit 30 is arranged immediately above the maintenance mechanism 38, the laser head 37 is (the reflective mirrors M are) located upstream from the ejection head 32, or the position closer to the driven roller 46b.

More specifically, when the head unit 30 is sent to the position immediately above the maintenance mechanism 38 through operation of the SCARA robot 26, the laser head 37 (the reflective mirrors M) of the head unit 30 and the ejection head 32 (the nozzle surface 33a) are arranged between the drive roller 46a and the driven roller 46b. In this state, the reflective mirrors M are located upstream from the ejection head 32.

A cleaning liquid supply section 47 is formed between the drive roller 46a and the driven roller 46b. The cleaning liquid supply section 47 is located upstream from the reflective mirrors M and above the wiping sheet 38b. The cleaning liquid supply section 47 sprays the cleaning liquid Fc onto the wiping sheet 38b, which is reeled off the driven roller 46b.

A first pressing roller 48 and a second pressing roller 49 are arranged between the drive roller 46a and the driven roller 46b in such a manner that the wiping sheet 38b is held between the reflective mirrors M and the ejection head 32. The first and second pressing rollers 48, 49 rotate counterclockwise through the wiping sheet 38b. The wiping sheet 38b is pressed upward by the first and second pressing rollers 48, 49. The pressing force generated by the first and second pressing rollers 48, 49 constantly acts to cause slidable contact between the wiping sheet 38b and the reflective surfaces Ma and the nozzle surface 33a.

In the second embodiment, the SCARA robot 26 is first operated to move the head unit 30 to the position immediately above the maintenance mechanism 38. The reflective mirrors M are then pivoted to move the reflective mirrors M from the mirror reflecting positions to the mirror cleaning positions. Subsequently, the drive roller 46a is activated to rotate and the cleaning liquid supply section 47 is caused to spray the cleaning liquid Fc onto the wiping sheet 38b. The wiping sheet 38b, which has received the cleaning liquid Fc, thus contacts and slides on the reflective surfaces Ma and the nozzle surface 33a. This washes the adhered matter G off the reflective surfaces Ma and the nozzle surface 33a. The initial states of the ejection performance of the ejection head 32 and the optical characteristics of the laser head 37 (the laser beams B) are thus restored.

The second embodiment has the following advantages.

(1) The reflective mirrors M are secured to the lower end of the laser head 37 through the mirror securing section 45. The position of each reflective mirror M is switched between the mirror reflecting position and the mirror cleaning position. Specifically, when the wiping sheet 38b that has received the sprayed cleaning liquid Fc is moved along the nozzle surface 33a in a slidable contact manner, the wiping sheet 38b slides also on the reflective surface Ma of each reflective mirror M located at the mirror cleaning position.

In this manner, the adhered matter G is washed off the reflective surfaces Ma by the wiping sheet 38b. The initial states of the optical characteristics of the laser head 37 (the laser beams B) are thus restored. As a result, the optical characteristics of the laser beams B radiated onto the droplets Fb are stabilized and the controllability for shaping the dots D is improved.

(2) The wiping sheet 38b slides on the nozzle surface 33a of the ejection head 32 at a position downstream from the reflective mirrors M. Therefore, even if the liquid F flows from the nozzles N and received by the wiping sheet 38b, the liquid F is prevented from re-adhering to the reflective surfaces Ma of the reflective mirrors M.

The illustrated embodiments may be modified in the following forms.

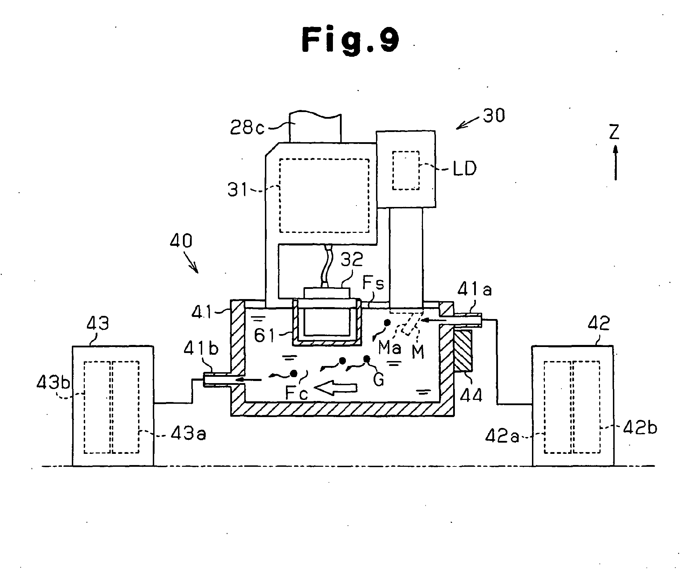

To immerse only the reflective mirrors M in the cleaning liquid Fc, a partition 61 may be provided, as illustrated in Fig. 9, to prevent the ejection head 32 from being exposed to the cleaning liquid Fc. Alternatively, for the same purpose, the cleaning bath 41 may be reduced in size. In this case, dissolution of the liquid F from the nozzles N into the cleaning liquid Fc is suppressed. Contamination of the reflective mirrors M by the liquid F is thus avoided.

In the first embodiment, for example, the cleaning liquid Fc may be sprayed onto the reflective mirrors M in the cleaning bath 41. That is, the reflective surfaces Ma may be cleaned in any suitable manner as long as the cleaning liquid Fc is supplied to the reflective surfaces Ma and the adhered matter G is thus removed.

In the first embodiment, the cleaning liquid Fc may be volatile. In this case, the nozzle surface 33a and the reflective mirrors M dry naturally after having been cleaned.

In the second embodiment, for example, the wiping sheet 38b may slide on only the reflective mirrors M. In this case, contamination of the reflective mirrors M by the liquid F from the nozzles N is avoided.

In each of the first and second embodiments, a carriage and a movable stage may be provided instead of the SCARA robot 26. The carriage holds the head unit 30 and moves on the base 21 in a specific direction. The movable stage carries the substrate 2 and moves in a direction perpendicular to the specific direction. That is, any suitable structure may be employed as long as the head unit 30 is movable relative to the corresponding mother substrate 2M.

In each of the first and second embodiments, the droplets Fb may be moved in a desired direction by energy generated by the laser beams B. Alternatively, the laser beams may be radiated onto only the outer ends of the droplets Fb, causing solidification (pinning) only in the surfaces of the droplets Fb. In other words, the present invention is applicable to any suitable method by which a pattern is formed through radiation of the laser beams B onto the droplets Fb.

In each of the first and second embodiments, a pattern may be formed by droplets Fb that provide oval dots or linear marks instead of the semispherical dots D.

In each of the first and second embodiments, for example, ion beams or plasma light may be employed instead of the laser beams B. That is, any suitable form of energy may be supplied to the droplets Fb on the substrate 2 as long as a pattern is formed by the droplets Fb.

In each of the first and second embodiments, various types of thin films, metal wirings, or color filters of the liquid crystal display 1 or a field effect type device (an FED or an SED) may be formed instead of the dots D as the marks forming the identification code 10. The field effect type device emits light from a fluorescent substance by electrons released by electron release elements. In other words, the droplets Fb may form any suitable marks.

In each of the illustrated embodiments, the substrate 2 may be, for example, a silicone substrate, a flexible substrate, or a metal substrate.

## Claims

1. A liquid ejection apparatus (20) comprising liquid ejecting means (32) that ejects a droplet (Fb) onto an object (2), energy beam radiating means (37) that radiates an energy beam (B) onto the droplet (Fb) on the target (2), the energy beam radiating means (37) having an optical component (M) that defines a radiation path of the energy beam (B), the apparatus (20) being **characterized by**:
cleaning means (40) that cleans the optical component (M) of the energy beam radiating means (37), wherein
the cleaning means (40) has a cleaning liquid supply means (41) that supplies a cleaning liquid (Fc) to the optical component (M).

2. The apparatus (20) according to claim 1, **characterized in that** the cleaning liquid supply means has a cleaning bath (41) that retains the cleaning liquid (Fc),
wherein the optical component (M) is immersed in the cleaning liquid (Fc) in the cleaning bath (41).

3. The apparatus (20) according to claim 2, **characterized in that** the cleaning liquid supply means further includes an oscillating section (44) that causes oscillation of the cleaning liquid (Fc) in the cleaning bath (41).

4. The apparatus (20) according to claims 2 or 3, **characterized in that** the cleaning liquid supply means further includes an inlet section (41a) through which the cleaning liquid (Fc) flows into the cleaning bath (41) and an outlet section (41b) through which the cleaning liquid (Fc) flows out from the cleaning bath (41).

5. The apparatus (20) according to any one of claims 2 to 4, **characterized in that** the cleaning liquid supply means immerses and cleans the liquid ejecting means (32) in the cleaning liquid (Fc) in the cleaning bath (41).

6. The apparatus (20) according to claim 5, **characterized in that** the cleaning liquid supply means includes an inlet section (41a) provided in the vicinity of the position at which the optical component (M) is immersed in the cleaning bath (41) and introduces the cleaning liquid (Fc) into the cleaning bath and an outlet section (41b) arranged in the vicinity of the position at which the liquid ejecting means (32) is immersed in the cleaning bath (41) and drains the cleaning liquid (Fc) from the cleaning bath (41).

7. The apparatus (20) according to claim 1, **characterized in that** the cleaning means (40) has a wiping member (38b) that wipes an optical surface (Ma) of the optical component (M).

8. The apparatus (20) according to claim 7, **characterized in that** the wiping member (38b) wipes the liquid ejecting means (32) after wiping the optical surface (Ma).

9. The apparatus (20) according to any one of the claims 1 to 8, **characterized in that** the energy beam is a laser beam (B) that dries the droplet (Fb) on the object 2.

## Patentansprüche

1. Flüssigkeitsausstoßvorrichtung (20), umfassend, ein Flüssigkeitsausstoßmittel (32), das ein Tröpfchen (Fb) auf ein Objekt (2) ausstößt, ein Energiestrahlausstrahlungsmittel (37), das einen Energiestrahl (B) auf das Tröpfchen (Fb) auf dem Ziel (2) ausstrahlt, wobei das Energiestrahlausstrahlungsmittel (37) eine optische Komponente (M) aufweist, die einen Ausstrahlungsweg des Energiestrahls (B) definiert, wobei die Vorrichtung (20) **gekennzeichnet ist, durch**:
ein Reinigungsmittel (40), das die optische Komponente (M) des Energiestrahlausstrahlungsmittels (37) reinigt, bei der
das Reinigungsmittel (40) ein Reinigungsflüssigkeitszufuhrmittel (41) aufweist, das eine Reinigungsflüssigkeit (Fc) der optischen Komponente (M) zuführt.

2. Vorrichtung (20) nach Anspruch 1, **dadurch gekennzeichnet, dass** das Reinigungsflüssigkeitszufuhrmittel ein Reinigungsbad (41) aufweist, das die Reinigungsflüssigkeit (Fc) aufbewahrt,
bei der die optische Komponente (M) in die Reinigungsflüssigkeit (Fc) in dem Reinigungsbad (41) eingetaucht wird.

3. Vorrichtung (20) nach Anspruch 2, **dadurch gekennzeichnet, dass** das Reinigungsflüssigkeitszufuhrmittel ferner einen oszillierenden Bereich (44) enthält, der Oszillationen der Reinigungsflüssigkeit (Fc) in dem Reinigungsbad (41) bewirkt.

4. Vorrichtung (20) nach Anspruch 2 oder 3, **dadurch gekennzeichnet, dass** das Reinigungsflüssigkeitszufuhrmittel ferner einen Einlassbereich (41a), durch den die Reinigungsflüssigkeit (Fc) in das Reinigungsbad (41) hinein fließt, und einen Auslassbereich (41b), durch den die Reinigungsflüssigkeit (Fc) aus dem Reinigungsbad (41) heraus fließt, enthält.

5. Vorrichtung (20) nach einem der Ansprüche 2 bis 4, **dadurch gekennzeichnet, dass** das Reinigungsflüssigkeitszufuhrmittel das Flüssigkeitsausstoßmittel (32) in die Reinigungsflüssigkeit (Fc) in dem Reinigungsbad (41) eintaucht und reinigt.

6. Vorrichtung (20) nach Anspruch 5, **dadurch gekennzeichnet, dass** das Reinigungsflüssigkeitszufuhrmittel einen Einlassbereich (41a), der in der Umgebung der Position vorgesehen ist, an der die optische Komponente (M) in das Reinigungsbad (41) eingetaucht wird und die Reinigungsflüssigkeit (Fc) in das Reinigungsbad einbringt, und einen Auslassbereich (41b) enthält, der in der Umgebung der Position angeordnet ist, an der das Flüssigkeitsausstoßmittel (32) in das Reinigungsbad (41) eingetaucht wird und die Reinigungsflüssigkeit (Fc) aus dem Reinigungsbad (41) abführt.

7. Vorrichtung (20) nach Anspruch 1, **dadurch gekennzeichnet, dass** das Reinigungsmittel (40) ein Wischelement (38b) aufweist, das über eine optische Oberfläche (Ma) der optischen Komponente (M) wischt.

8. Vorrichtung (20) nach Anspruch 7, **dadurch gekennzeichnet, dass** das Wischelement (38b) über das Flüssigkeitsausstoßmittel (32) wischt, nach dem Wischen über die optische Oberfläche (Ma).

9. Vorrichtung (20) nach einem der Ansprüche 1 bis 8, **dadurch gekennzeichnet, dass** der Energiestrahl ein Laserstrahl (B) ist, der das Tröpfchen (Fb) auf dem Objekt (2) trocknet.

## Revendications

1. Appareil (20) d'éjection de liquide comprenant un moyen (32) d'éjection de liquide qui éjecte une gouttelette (Fb) sur un objet (2), un moyen (37) à irradiation de faisceau d'énergie qui irradie un faisceau d'énergie (B) sur la gouttelette (Fb) sur la cible (2), le moyen (37) à irradiation de faisceau d'énergie ayant une composante optique (M) qui définit un chemin d'irradiation du faisceau d'énergie (B), l'appareil (20) étant **caractérisé par** :
un moyen de nettoyage (40) qui nettoie la composante optique (M) du moyen (37) à irradiation de faisceau d'énergie, où
le moyen de nettoyage (40) dispose d'un moyen (41) d'alimentation en liquide de nettoyage qui alimente un liquide de nettoyage (Fc) à la composante optique (M).

2. Appareil (20) selon la revendication 1, **caractérisé en ce que** le moyen d'alimentation en liquide de nettoyage dispose d'un bain de nettoyage (41) qui contient le liquide de nettoyage (Fc),
où la composante optique (M) est immergée dans le liquide de nettoyage (Fc) dans le bain de nettoyage (41).

3. Appareil (20) selon la revendication 2, **caractérisé en ce que** le moyen d'alimentation en liquide de nettoyage comprend en plus une section oscillante (44) qui provoque une oscillation du liquide de nettoyage (Fc) dans le bain de nettoyage (41).

4. Appareil (20) selon les revendications 2 ou 3, **caractérisé en ce que** le moyen d'alimentation en liquide de nettoyage comprend en plus une section d'entrée (41a) à travers laquelle le liquide de nettoyage (Fc) s'écoule dans le bain de nettoyage (41) et une section de sortie (41b) à travers laquelle le liquide de nettoyage (Fc) quitte le bain de nettoyage (41).

5. Appareil (20) selon l'une quelconque des revendications 2 à 4, **caractérisé en ce que** le moyen d'alimentation en liquide de nettoyage immerge et nettoie le moyen (32) d'éjection de liquide dans le liquide de nettoyage (Fc) dans le bain de nettoyage (41).

6. Appareil (20) selon la revendication 5, **caractérisé en ce que** le moyen d'alimentation en liquide de nettoyage comprend une section d'entrée (41a) fournie à proximité de la position à laquelle la composante optique (M) est immergée dans le bain de nettoyage (41) et introduit le liquide de nettoyage (Fc) dans le bain de nettoyage et une section de sortie (41 b) agencée à proximité de la position à laquelle le moyen (32) d'éjection de liquide est immergé dans le bain de nettoyage (41) et évacue le liquide de nettoyage (Fc) du bain de nettoyage (41).

7. Appareil (20) selon la revendication 1, **caractérisé en ce que** le moyen de nettoyage (40) dispose d'un élément d'essuyage (38b) qui essuie une surface optique (Ma) de la composante optique (M).

8. Appareil (20) selon la revendication 7, **caractérisé en ce que** l'élément d'essuyage (38b) essuie le moyen (32) d'éjection de liquide après l'essuyage de la surface optique (Ma).

9. Appareil (20) selon l'une quelconque des revendications 1 à 8, **caractérisé en ce que** le faisceau d'énergie est un faisceau laser (B) qui sèche la gouttelette (Fb) sur l'objet 2.
